# EUROPEAN PATENT SPECIFICATION

(11) **EP 2 120 517 B1**
(45) Date of publication and mention of the grant of the patent: **01.08.2018**
(21) Application number: 07702270.5
(22) Date of filing: 05.02.2007
(51) Int. Cl.: H05K 1/14, H05K 3/36, H05K 3/46, H01L 23/48, H01L 23/12, H01L 23/50

(54) **A MUTUAL CONNECTION STRUCTURE BETWEEN MULTI-LAYER BOARDS AND MANUFACTURING METHOD THEREOF**
GEGENSEITIGE VERBINDUNGSSTRUKTUR ZWISCHEN MEHRSCHICHT-PLATTEN UND HERSTELLUNGSVERFAHREN DAFÜR
STRUCTURE D'ASSEMBLAGE COMMUNE ENTRE DES PANNEAUX MULTICOUCHE ET PROCÉDÉ DE FABRICATION ASSOCIÉ

(43) Date of publication of application: 18.11.2009
(73) Proprietor: Princo Corp., Taiwan (CN)
(72) Inventor: YANG, Chihkuang, Taiwan 300 (CN)
(74) Representative: Jeannet, Olivier
(86) International application number: PCT/CN2007/000379
(87) International publication number: WO 2008/095338

(56) References cited:
- CN-A- 1 351 815
- CN-A- 1 575 094
- CN-A- 1 652 663
- CN-A- 1 703 136
- CN-A- 1 713 802
- CN-C- 1 186 971
- CN-C- 1 231 965
- CN-Y- 2 786 910
- JP-A- 05 243 741
- JP-A- 07 058 431
- JP-A- 08 236 937
- JP-A- H08 139 455
- JP-A- 2002 314 257

## Description

### Field of the Invention

The present invention generally relates to a hybrid structure of multi-layer substrates and the manufacture method thereof, and more particularly to a hybrid structure of different kinds of multi-layer substrates and the manufacture method thereof which can be applied to different kinds of chip devices.

### Background of the Invention

Miniaturization for all electronic productions is an unavoidable trend in this modern world. While the scales of the semiconductor chips continuously get smaller, the scale of the related technology for packaging needs to be microminiaturized to follow the scale of the semiconductor chip is also unavoidable. Today, because the integration of integrated circuits has been greatly increased, using a multi-layer substrate to package different kinds of chip devices is necessary to integrate different kinds of functions to obtain a high performance integration system consequentially. For example, an integration system may comprise many kinds of chip devices, such as a logic circuit component, a memory, an analog component, an optoelectronic component, a microelectric mechanical component or a luminous component. Generally, the kinds of chip devices need to connect with each other through one shared package substrate (such as a mainboard) according to prior arts. That is, if one chip device can be connected to another chip device directly, the integration of package can be increased to microminiaturize the whole system further. A Stacked Chip Scale Package (SCSP) is proposed to package several chips nowadays, is called a 3D-package. However, such a 3D-package concept is limited in a rigid system package.

For meeting the variety of modern electronic production, a flexible multi-layer substrate or a non-flat substrate can be used for high density package. According to prior arts, the connection for two independent multi-layer substrates is established through connectors or through one shared package substrate. Therefore, for corresponding to a flexible or irregular package to increase integration complexity and reducing package volume, even applying for a System-In-Package, connection becomes a great topic and a challenge for the package technology today.

Therefore, development of a hybrid structure of multi-layer substrates and manufacture method thereof to connect different kinds of chip devices directly without a shared package substrate, this will reduce the package volume of the whole system to increase the package integration and to provide a flexible package. Accordingly, microminiaturization of whole system can be achieved.

JP H08-139455A is a related prior art in this field.

### Summary of the Invention

An objective of the present invention is to provide a hybrid structure of multi-layer substrates and manufacture method thereof to connect different kinds of chip devices directly.

Another objective of the present invention is to provide a hybrid structure of multi-layer substrates and manufacture method thereof to reduce package volume of the whole system for increasing the package integration and provide a flexible package.

The hybrid structure of multi-layer substrates of the present invention comprises at least a first multi-layer substrate and a second multi-layer substrate, as disclosed in the claims.

Moreover, the present invention also provides a manufacture method of a hybrid structure of multi-layer substrates for connecting chip devices, as disclosed in the claims.

### Brief Description of the Drawings

FIG. 1 illustrates a profile drawing of a hybrid structure of multi-layer substrates according to a first embodiment of the present invention;
FIG. 2 illustrates a profile drawing of a hybrid structure of multi-layer substrates according to a first embodiment of the present invention wherein the interface adhesion enhancing process implementing areas are indicated with bold lines;
FIG. 3A and FIG 3B illustrate a flowchart of a manufacture method of the hybrid structure of multi-layer substrates according to the present invention; and
FIG. 4 illustrates profile drawing of a hybrid structure of multi-layer substrates according to a second embodiment of the present invention wherein the connection of one second metal layer and the corresponding second dielectric layer is retained as dividing the second multi-layer substrate and the third multi-layer substrate.

### Detailed Description of the Invention

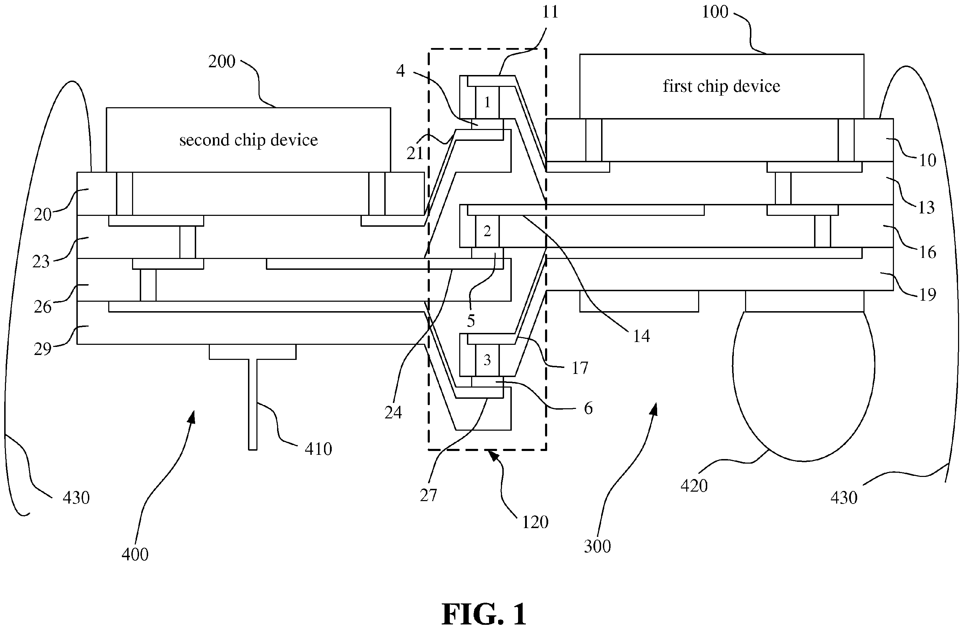

Please refer to FIG. 1, which illustrates a profile drawing of a hybrid structure of multi-layer substrates according to a first embodiment of the present invention. The hybrid structure of multi-layer substrates comprises a first multi-layer substrate 300, a second multi-layer substrate 400 and VIAs 1, 2, 3 formed in the first multi-layer substrate 300. A first chip device 100 is positioned on a first outer surface of the first multi-layer substrate 300. A second chip device 200 is positioned on a first outer surface of the second multi-layer substrate 400. Either the first chip device 100 or the second chip device 200 can be a logic circuit component, a memory, an analog component, an optoelectronic component, a microelectric mechanic component, a luminous component or any other components. The hybrid structure of multi-layer substrates may further comprise a third substrate (not shown in Figures). The third substrate can be employed to connect the first multi-layer substrate 300 or the second multi-layer substrate 400 via a pin 410 or Ball Mount 420. Alternatively, the third substrate also can be employed to connect the first chip device 100 or the second chip device 200.

The first multi-layer substrate 300 comprises first dielectric layers 10, 13, 16, 19 and first metal layers 11, 14, 17. The second multi-layer substrate 400 comprises second dielectric layers 20, 23, 26, 29 and second metal layers 21, 24, 27. The first chip device 100 is connected with the first dielectric layer 10 of the first multi-layer substrate 300. The second chip device 200 is connected with the second dielectric layer 20.

As shown in FIG. 1, regarding the first multi-layer substrate 300, the border districts of the first metal layer 11 and the first dielectric layer 13 are connected therewith, the border districts of the first metal layer 14 and the first dielectric layer 16 connected therewith and the border districts of the first metal layer 17 and the first dielectric layer 19 connected therewith are separated from adjacent first metal layers and adjacent first dielectric layers. Similarly, regarding the second multi-layer substrate 400, the border districts of the second metal layer 21 and the second dielectric layer 23 are connected therewith, the border districts of the second metal layer 24 and the second dielectric layer 26 connected therewith and the border districts of the second metal layer 27 and the second dielectric layer 29 connected therewith are separated from adjacent second metal layers and adjacent second dielectric layers respectively. Besides, the VIAs 1, 2, 3 are located at the border districts of the first dielectric layers 13, 16, 19 respectively.

The VIAs 1, 2, 3 have electric conductors including electric conduction material therein. The electric conductors in the VIAs 1, 2, 3 can be formed when the first metal layers 11, 14, 17 are formed by using Lithography Etching, Electroplating or Metal Lift-off, that is, the VIAs 1, 2, 3 fill up with the electric conduction material when the first metal layers 11, 14, 17 are formed. Therefore, the electric conduction material is the same metal element of the first metal layers 11, 14, 17. However, the electric conductors are not limited to aforementioned but the process of forming the electric conductors can be independent of the process of forming the first metal layers 11, 14, 17. The electric conduction material in the VIAs 1, 2, 3 can be different from the metal element of the first metal layers 11, 14, 17 according to different demands. For example, the VIAs 1, 2, 3 can fill up with the electric conductors after separating the border districts of the first metal layers and the first dielectric layers connected therewith from adjacent first metal layers and adjacent first dielectric layers of the first multi-layer substrate 300.

The separated border districts of the second metal layers 21, 24, 27 of the second multi-layer substrate 400 are connected with the electric conductors in the VIAs 1, 2, 3 located at the border districts of the first dielectric layers 13, 16, 19 respectively when the second multi-layer substrate 400 is going to connect with the first multi-layer substrate 300 to form a connection section 120 of the hybrid structure of multi-layer substrates as shown in FIG. 1. The interconnection method of bonders 4, 5, 6 can use bondings such as tin finish bonding, Eutectic bonding, Anisotropic Conductive Film bonding, Gold-Gold bonding or Gold-Copper bonding. By such interconnection, the second metal layers 21, 24, 27 and the first metal layers 11, 14, 17 are interconnected and by such hybrid structure of multi-layer substrates, a direct interconnection of the first multi-layer substrate 300 and the second multi-layer substrate 400 can be realized. Comparing with prior arts, the direct interconnection of the first multi-layer substrate 300 and the second multi-layer substrate 400 is achieved by utilizing the separated border districts of the multi-layer substrates. Therefore, package integration can be increased and package volume of the whole system can be reduced and provide effectively a flexible package for application of a flexible electronic system.

In the first embodiment of the present invention, the VIAs 1, 2, 3 at the first dielectric layers 13, 16, 19 are connected with the second metal layers 21, 24, 27 one by one but the interconnection is not limited thereto. Selective interconnection or one by many can also be illustrated.

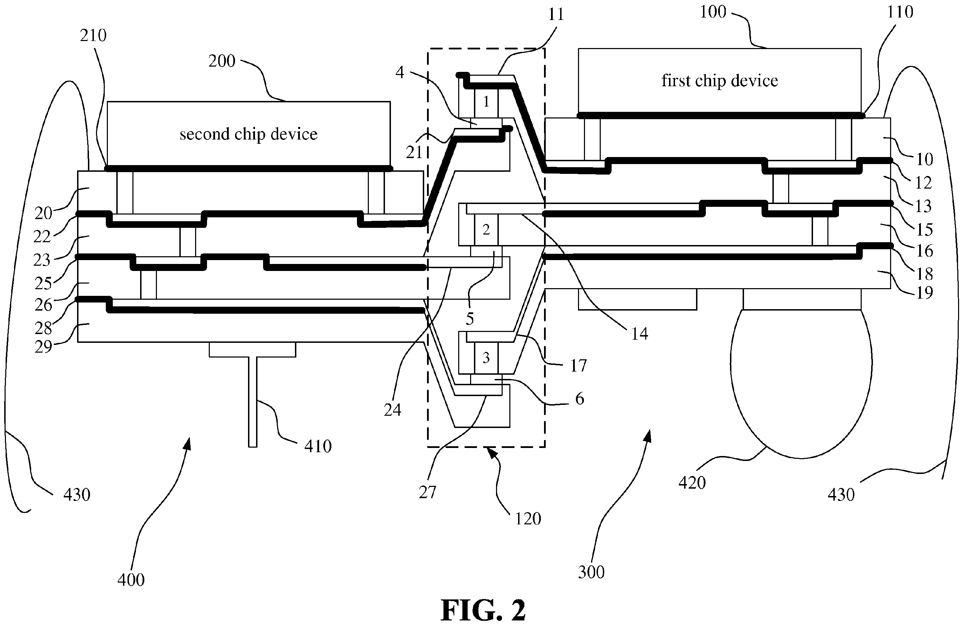

Please refer to FIG. 2, which illustrates a profile drawing of a hybrid structure of multi-layer substrates according to a first embodiment of the present invention wherein the interface adhesion enhancing process implementing areas are indicated with bold lines. An interface adhesion enhancing process can be implemented between the first chip device 100 and the first multi-layer substrate 300, or between the second chip device 200 and the second multi-layer substrate 400 to increase adhesion intensities between the first chip device 100, the second chip device 200 and the first outer surfaces of the first multi-layer substrate 300 and the second multi-layer substrate 400 (the adhesion intensity between dielectric layer and silicon). Moreover, an interface adhesion enhancing process is also implemented on rest districts of the first metal layers, the second metal layers, the first dielectric layers and the second dielectric layers except the separated border districts to increase adhesion intensity on the aforesaid rest surfaces. Significantly, an interface adhesion enhancing process is not implemented on the border districts between the first dielectric layer 13 and the first metal layer 14, between the first dielectric layer 16 and the first metal layer 17, between the first dielectric layer 16 and the first metal layer 17, between the second dielectric layer 23 and the second metal layer 24 or between the second dielectric layer 26 and the second metal layer 27.Alternatively, an interface adhesion weakening process can be implemented between those border district. Because the interface adhesion enhancing process is implemented on the rest districts except the border districts between the dielectric layers, the border districts which are not implemented with the interface adhesion enhancing process or implemented with the interface adhesion weakening process can be easily separated from the other adjacent border districts of layers.

The way to separate the border districts of the multi-layer substrates can be using two adhesive tapes (such as UV tape) to stick on the first outer surface and the second outer surface of the first multi-layer substrate 300 or the second multi-layer substrate 400, first; and then, rending the two tapes to separate the border districts which are not implemented with the interface adhesion enhancing process. Repeating the sticking and rending procedures, the border districts of the layers which are not implemented with the interface adhesion enhancing process can be separated. However, the metal layers 11, 14, 17, 21, 24, 27 are connected with the dielectric layers 13, 16, 19, 23, 26, 29. With a concept of selective interface adhesion enhancing process between the dielectric layers, the hybrid structure of the first multi-layer substrate 300 and the second multi-layer substrate 400 can be accomplished. For example, material of the dielectric layers is polyimide; the aforesaid interface adhesion enhancing process can be an oxygen or argon plasma process.

As aforementioned, the third substrate can be use to connect the first outer surface of the first multi-layer substrate 300 or the first outer surface of the second multi-layer substrate 400. The connect method can be BGA package, LGA package, PGA package or Wire Bond Package. In a case that the first multi-layer substrate 300, the second multi-layer substrate 400 and the third substrate are all flexible multi-layer interconnection substrates, the hybrid structure of the multi-layer substrates of the present invention can provide a flexible package for those aforesaid flexible multi-layer interconnection substrates.

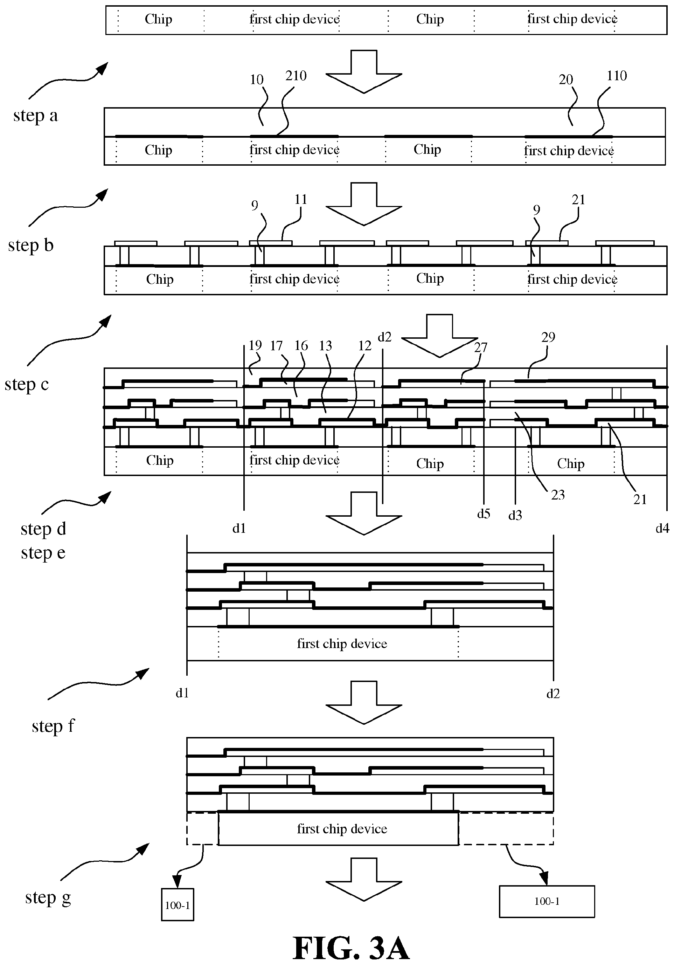

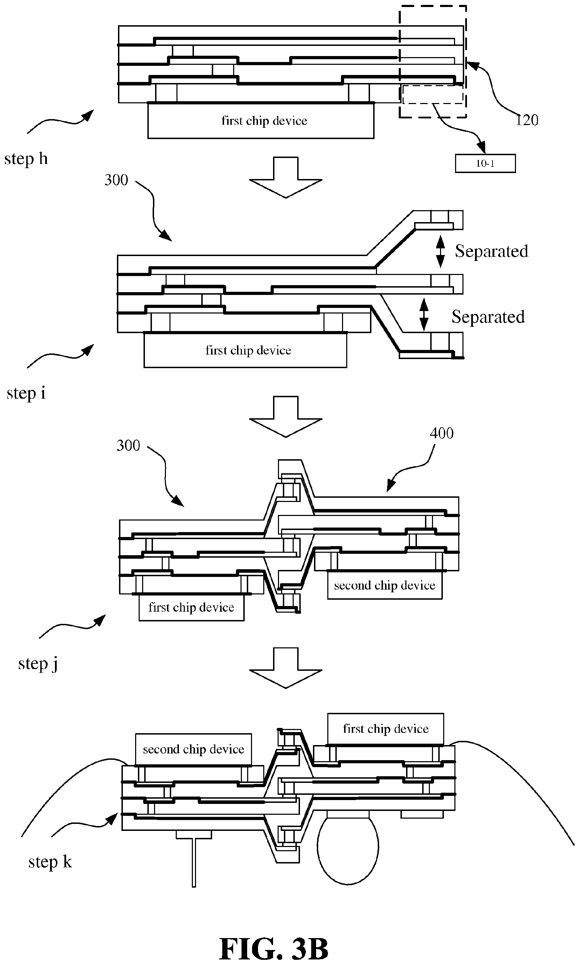

Please refer to FIG. 3A and FIG 3B which illustrate a flowchart of a manufacture method of the hybrid structure of multi-layer substrates according to the present invention. The manufacture method of the present invention comprises steps of:
Step a. providing a device wafer including a plurality of chip devices;
Step b. implementing an interface adhesion enhancing process 110, 210 on the chip devices to increase adhesion intensity on surfaces of the first chip devices and then coating dielectric layers 10, 20;
Step c. forming a plurality of VIAs at predetermined positions 9 and metal layers 11, 21 on the dielectric layer at predetermined areas of the metal layers;
Step d. implementing an interface adhesion enhancing process 12, 22 on rest districts of the metal layer 11, 21 and the dielectric layer 10, 20 except the border district to increase adhesion intensity of the rest districts and coating another dielectric layers 13, 23;
Step e. repeating the step c and the step d to form the multi-layer substrates;
Step f. dividing the chip devices and corresponding multi-layer substrates along edges of the border districts (vertical lines, d2, d3 shown in Figures for Step d. and Step e.);
Step g. removing parts 100-1 of the device wafer without chip devices;
Step h. removing a border district 10-1 of the dielectric layer 10 adjacent to the chip device 100 to reveal a border district of the corresponding metal layer 11 of the dielectric layer 10 by using laser or separating dielectric layer;
Step i. separating a border district of at least one metal layer connecting with a border district of the corresponding dielectric layer from adjacent metal layers and adjacent dielectric layers for each multi-layer substrate;
Step j. connecting electric conductor in a VIA of a first metal layer of the first multi-layer substrate 300 with a separated border district of a metal layer of the second multi-layer substrate 400 by using tin finish bonding, Eutectic bonding, Anisotropic Conductive Film bonding, Gold-Gold bonding or Gold-Copper bonding to complete the hybrid structure of multi-layer substrates; and
Step k. connecting the second outer surfaces of the first multi-layer substrate 300 and the second multi-layer substrate 400 with a third substrate (not shown in FIG. 3B). As aforementioned, the connecting method can be BGA package, LGA package, PGA package or Wire Bond Package. Although the manufacture method of the first multi-layer substrate 300 is illustrated in FIG. 3A and FIG. 3B, the manufacture method of the second multi-layer substrate 400 or the third substrate is similar thereto.

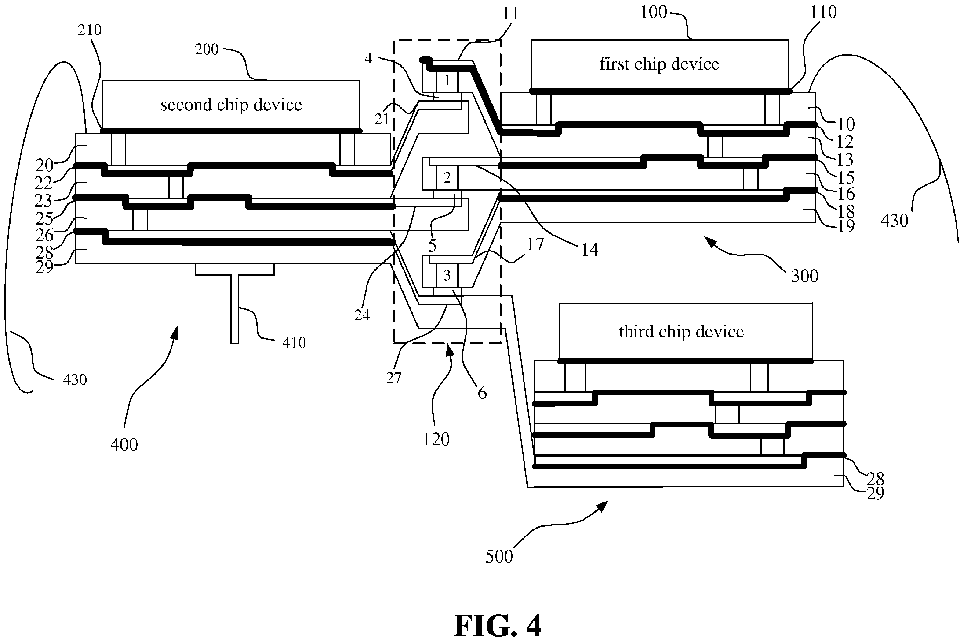

Please refer to FIG. 4, which illustrates profile drawing of a hybrid structure of multi-layer substrates according to a second embodiment of the present invention wherein the connection of a second metal layer 27 and the corresponding second dielectric layer 29 is retained as dividing the second multi-layer substrate and the third multi-layer substrate. Please also refer to the figures for Step d. and Step e. shown in FIG. 3A about the manufacture method of the first multi-layer substrate 300 according to the present invention. The manufacture method of the second multi-layer substrate 400 is similar to thereto. Supposing that the second chip device 200 and the second multi-layer substrate 400 are between the vertical lines d3, d4; a third chip device and the third multi-layer substrate 500 are between the vertical lines d2, d3, the difference in Step f. from the first embodiment is dividing the chip devices and corresponding multi-layer substrates along the vertical lines d2, d4 completely but dividing along the vertical line d5 from the chip device stops at second metal layer 27 and the dielectric 29; dividing along the vertical line d3 from the chip device stops at second metal layer 21 and the dielectric 23. Then, the second metal layers and the second dielectric layers between the vertical lines d3, d5 are separated. Accordingly, the second multi-layer substrate 400 and the third multi-layer substrate 500 own the second metal layer 27 and the dielectric 29 together. Similarly as described in the first embodiment, the hybrid structure of the first multi-layer substrate 300 and the second multi-layer substrate 400 remains. Therefore, the present invention provides a concept having more possibilities of multiple interconnections for multi-layer substrates.

In conclusion, the present invention provides a hybrid structure of multi-layer substrates and manufacture method thereof to connect different kinds of chip devices directly through the hybrid structure of the respective multi-layer substrates connecting the chip devices therewith and without a shared substrate. The hybrid structure of multi-layer substrates according to the present invention can reduce the package volume of the whole system for increasing the package integration and further provide a flexible package for application of a flexible electronic system. Comparing to prior arts, the present invention has high integration and high package integration of System-In-Package either for the package among chip devices or for package among multi-layer substrates.

As is understood by a person skilled in the art, the foregoing preferred embodiments of the present invention are illustrative rather than limiting of the present invention. It is intended that they cover various modifications and similar arrangements be included within the scope of the appended claims, the scope of which should be accorded the broadest interpretation so as to encompass all such modifications and similar structure.

## Claims

1. A hybrid structure of multi-layer substrates, which comprises a first multi-layer substrate (300), stacking up a plurality of first metal layers (11; 14; 17) and a plurality of first dielectric layers (10; 13; 16; 19) alternately, and having a plurality of VIAs (1; 2; 3); and a second multi-layer substrate (400), stacking up a plurality of second metal layers (21; 24; 27) and a plurality of second dielectric layers (20; 23; 26; 29) alternately, **characterized in that**:
the first multi-layer substrate (300) has a border district of at least one first metal layer (11; 14; 17) that connects with a border district of a corresponding first dielectric layer (10; 13; 16; 19), and the border districts are separated from adjacent first metal layers (11; 14; 17) and adjacent first dielectric layers (10; 13; 16; 19), and further **characterized in that**:
the second multi-layer substrate (400) has a border district of at least one second metal layer (21; 24; 27) that connects with a border district of a corresponding second dielectric layer (20; 23; 26; 29), and the border districts are separated from adjacent second metal layers (21; 24; 27) and adjacent second dielectric layers (20; 23; 26; 29),
wherein the VIAs (1; 2; 3) are located at the border districts of the first dielectric layers (10; 13; 16; 19) and each VIA (1; 2; 3) has electric conductor therein to connect at least one first metal layer (11; 14; 17) with at least one second metal layer (21; 24; 27) to form a connection section (120); and
wherein the first multi-layer substrate (300) and the second multi-layer substrate (400) are flexible substrates.

2. The hybrid structure of claim 1, **characterized in that** an interface adhesion enhancing process (12; 15; 18) is implemented on rest districts of the first metal layers (11; 14; 17) and the corresponding first dielectric layers (10; 13; 16; 19) except the border districts thereof to increase adhesion intensity on the rest districts.

3. The hybrid structure of claim 1, **characterized in that** an interface adhesion enhancing process (22; 25; 28) is implemented on rest districts of the second metal layers (21; 24; 27) and the corresponding second dielectric layers (20; 23; 26; 29) except the border districts thereof to increase adhesion intensity on the rest districts.

4. A manufacture method of a hybrid structure of multi-layer substrates (300; 400) for connecting chip devices (100; 200), **characterized in that** the manufacture method comprises steps of:
separating a border district of at least one metal layer (11; 14; 17; 21; 24; 27) and a corresponding dielectric layer (10; 13; 16; 19; 20; 23; 26; 29) from adjacent metal layers (11; 14; 17; 21; 24; 27) and adjacent dielectric layers (10; 13; 16; 19; 20; 23; 26; 29) for each multi-layer substrate (300; 400); and
connecting electric conductor in a VIA (1; 2; 3) of a first metal layer (11; 14; 17) of one multi-layer substrate (300) with a separated border district of a metal layer (21; 24; 27) of another multi-layer substrate (400) to form a connection section (120),
wherein each of the multi-layer substrates (300; 400) is a flexible substrate.

5. The manufacture method of claim 4, **characterized in that** the manufacture method further comprises a step of removing a border district of the dielectric layer (10; 13; 16; 19; 20; 23; 26; 29) adjacent to the chip devices (100; 200) to reveal a border district of the corresponding metal layer (11; 14; 17; 21; 24; 27).

6. The manufacture method of claim 4, **characterized in that** the manufacture method further comprises a step of forming the multi-layer substrates (300; 400) on the chip devices (100; 200) before the separating step.

7. The manufacture method of claim 6, **characterized in that** the manufacture method further comprises a step of implementing an interface adhesion enhancing process (110; 210) on the chip devices (100; 200) during the step of forming the multi-layer substrates (300; 400).

8. The manufacture method of claim 6, **characterized in that** the step of forming the multi-layer substrates (300; 400) further comprises steps of:
(A) coating a dielectric layer (10; 13; 16; 19; 20; 23; 26; 29) on the surfaces of the chip devices (110; 210);
(B) forming a plurality of VIAs (1; 2; 3) at the dielectric layer (10; 13; 16; 19; 20; 23; 26; 29) and a metal layer (11; 14; 17; 21; 24; 27) on the dielectric layer (10; 13; 16; 19; 20; 23; 26; 29);
(C) implementing an interface adhesion enhancing process (12; 15; 18; 22; 25; 28) on rest districts of the metal layer (11; 14; 17; 21; 24; 27) and the dielectric layer (10; 13; 16; 19; 20; 23; 26; 29) except the border district to increase adhesion intensity of the rest districts and coating another dielectric layer (10; 13; 16; 19; 20; 23; 26; 29);
(D) repeating the step (B) and the step (C) to form the multi-layer substrates (300; 400).

9. The manufacture method of claim 8, **characterized in that** the manufacture method further comprises a step of providing a device wafer including the chip devices (100; 200).

10. The manufacture method of claim 9, **characterized in that** the manufacture method further comprises a step of dividing the chip devices (100; 200) and corresponding multi-layer substrates (300; 400) along edges of the border districts.

11. The manufacture method of claim 10, **characterized in that** the manufacture method further comprises a step of removing parts of the device wafer without chip devices (100; 200) after the step of dividing the chip devices (100; 200).

12. The manufacture method of claim 4, **characterized in that** the manufacture method further comprises a step of connecting the multi-layer substrates (300; 400) with a third substrate (500) after the connecting step, wherein the third substrate (500) is a flexible substrate.

## Patentansprüche

1. Hybridstruktur aus mehrschichtigen Substraten, die ein erstes mehrschichtiges Substrat (300) umfasst, in dem abwechselnd mehrere erste Metallschichten (11, 14, 17) und mehrere erste dielektrische Schichten (10, 13, 16, 19) aufgestapelt sind und das mehrere Durchkontaktierungen (1, 2, 3) aufweist, und ein zweites mehrschichtiges Substrat (400), in dem abwechselnd mehrere zweite Metallschichten (21, 24, 27) und mehrere zweite dielektrische Schichten (20, 23, 26, 29) aufgestapelt sind, **dadurch gekennzeichnet, dass**:
das erste mehrschichtige Substrat (300) einen Grenzbereich von mindestens einer ersten Metallschicht (11, 14, 17) aufweist, die mit einem Grenzbereich einer entsprechenden ersten dielektrischen Schicht (10, 13, 16, 19) verbunden ist, und dass die Grenzbereiche von benachbarten ersten Metallschichten (11, 14, 17) und benachbarten ersten dielektrischen Schichten (10, 13, 16, 19) getrennt sind, und ferner **dadurch gekennzeichnet, dass**:
das zweite mehrschichtige Substrat (400) einen Grenzbereich von mindestens einer zweiten Metallschicht (21, 24, 27) aufweist, die mit einem Grenzbereich einer entsprechenden zweiten dielektrischen Schicht (20, 23, 26, 29) verbunden ist, und dass die Grenzbereiche von benachbarten zweiten Metallschichten (21, 24, 27) und benachbarten zweiten dielektrischen Schichten (20, 23, 26, 29) getrennt sind,
wobei die Durchkontaktierungen (1, 2, 3) an den Grenzbereichen der ersten dielektrischen Schichten (10, 13, 16, 19) angeordnet sind und jede Durchkontaktierung (1, 2, 3) in sich einen elektrischen Leiter aufweist, um mindestens eine erste Metallschicht (11, 14, 17) mit mindestens einer zweiten Metallschicht (21, 24, 27) zu verbinden, um einen Verbindungsabschnitt (120) zu bilden, und
wobei das erste mehrschichtige Substrat (300) und das zweite mehrschichtige Substrat (400) flexible Substrate sind.

2. Hybridstruktur nach Anspruch 1, **dadurch gekennzeichnet, dass** mit Ausnahme der Grenzbereiche an restlichen Bereichen der ersten Metallschichten (11, 14, 17) und den entsprechenden ersten dielektrischen Schichten (10, 13, 16, 19) ein Grenzflächen-Haftungsverstärkungsprozess (12, 15, 18) ausgeführt wird, um die Haftungsintensität an den restlichen Bereichen zu erhöhen.

3. Hybridstruktur nach Anspruch 1, **dadurch gekennzeichnet, dass** mit Ausnahme der Grenzbereiche an restlichen Bereichen der zweiten Metallschichten (21, 24, 27) und den entsprechenden zweiten dielektrischen Schichten (20, 23, 26, 29) ein Grenzflächen-Haftungsverstärkungsprozess (22, 25, 28) ausgeführt wird, um die Haftungsintensität an den restlichen Bereichen zu erhöhen.

4. Herstellungsverfahren für eine Hybridstruktur aus mehrschichtigen Substraten (300, 400) zum Verbinden von Chip-Vorrichtungen (100, 200), **dadurch gekennzeichnet, dass** das Herstellungsverfahren folgende Schritte umfasst:
Trennen eines Grenzbereichs mindestens einer Metallschicht (11, 14, 17, 21, 24, 27) und einer entsprechenden dielektrischen Schicht (10, 13, 16, 19, 20, 23, 26, 29) von benachbarten Metallschichten (11, 14, 17, 21, 24, 27) und benachbarten dielektrischen Schichten (10, 13, 16, 19, 20, 23, 26, 29) bei jedem mehrschichtigen Substrat (300, 400) und
Verbinden des elektrischen Leiters in einer Durchkontaktierung (1, 2, 3) einer ersten Metallschicht (11, 14, 17) eines mehrschichtigen Substrats (300) mit einem getrennten Grenzbereich einer Metallschicht (21, 24, 27) eines anderen mehrschichtigen Substrats (400), um einen Verbindungsabschnitt (120) zu bilden,
wobei jedes der mehrschichtigen Substrate (300, 400) ein flexibles Substrat ist.

5. Herstellungsverfahren nach Anspruch 4, **dadurch gekennzeichnet, dass** das Herstellungsverfahren ferner einen Schritt des Entfernens eines Grenzbereichs der zu den Chip-Vorrichtungen (100, 200) benachbarten dielektrischen Schicht (10, 13, 16, 19, 20, 23, 26, 29) umfasst, um einen Grenzbereich der entsprechenden Metallschicht (11, 14, 17, 21, 24, 27) freizulegen.

6. Herstellungsverfahren nach Anspruch 4, **dadurch gekennzeichnet, dass** das Herstellungsverfahren vor dem Schritt des Trennens ferner einen Schritt des Bildens der mehrschichtigen Substrate (300, 400) auf den Chip-Vorrichtungen (100, 200) umfasst.

7. Herstellungsverfahren nach Anspruch 6, **dadurch gekennzeichnet, dass** das Herstellungsverfahren ferner einen Schritt des Ausführens eines Grenzflächen-Haftungsverstärkungsprozesses (110, 210) an den Chip-Vorrichtungen (100, 200) während des Schritts des Bildens der mehrschichtigen Substrate (300, 400) umfasst.

8. Herstellungsverfahren nach Anspruch 6, **dadurch gekennzeichnet, dass** der Schritt des Bildens der mehrschichtigen Substrate (300, 400) ferner folgende Schritte umfasst:
(A) Auftragen einer dielektrischen Schicht (10, 13, 16, 19, 20, 23, 26, 29) auf die Oberflächen der Chip-Vorrichtungen (100, 200),
(B) Bilden mehrerer Durchkontaktierungen (1, 2, 3) auf der dielektrischen Schicht (10, 13, 16, 19, 20, 23, 26, 29) und einer Metallschicht (11, 14, 17, 21, 24, 27) auf der dielektrischen Schicht (10, 13, 16, 19, 20, 23, 26, 29),
(C) Ausführen eines Grenzflächen-Haftungsverstärkungsprozesses (12, 15, 18, 22, 25, 28) auf restlichen Bereichen der Metallschicht (11, 14, 17, 21, 24, 27) und der dielektrischen Schicht (10, 13, 16, 19, 20, 23, 26, 29) mit Ausnahme des Grenzbereichs, um die Haftungsintensität der restlichen Bereiche zu erhöhen, und Auftragen einer weiteren dielektrischen Schicht (10, 13, 16, 19, 20, 23, 26, 29),
(D) Wiederholen des Schritts (B) und des Schritts (C), um die mehrschichtigen Substrate (300, 400) zu bilden.

9. Herstellungsverfahren nach Anspruch 8, **dadurch gekennzeichnet, dass** das Herstellungsverfahren einen Schritt des Bereitstellens eines Vorrichtungs-Wafers umfasst, der die Chip-Vorrichtungen (100, 200) beinhaltet.

10. Herstellungsverfahren nach Anspruch 9, **dadurch gekennzeichnet, dass** das Herstellungsverfahren ferner einen Schritt des Abteilens der Chip-Vorrichtungen (100, 200) und der entsprechenden mehrschichtigen Substrate (300, 400) entlang der Ränder der Grenzbereiche umfasst.

11. Herstellungsverfahren nach Anspruch 10, **dadurch gekennzeichnet, dass** das Herstellungsverfahren nach dem Schritt des Abteilens der Chipvorrichtungen (100, 200) ferner einen Schritt des Entfernens von Teilen des Vorrichtungs-Wafers ohne Chip-Vorrichtungen (100, 200) umfasst.

12. Herstellungsverfahren nach Anspruch 4, **dadurch gekennzeichnet, dass** das Herstellungsverfahren nach dem Verbindungsschritt ferner einen Schritt des Verbindens der mehrschichtigen Substrate (300, 400) mit einem dritten Substrat (500) umfasst, wobei das dritte Substrat (500) ein flexibles Substrat ist.

## Revendications

1. Une structure hybride de substrats multicouches, qui comprend un premier substrat multicouche (300), empilant alternativement une pluralité de premières couches métalliques (11 ; 14 ; 17) et une pluralité de premières couches diélectriques (10 ; 13 ; 16, 19), et ayant une pluralité de VIA (1 ; 2 ; 3) ; et un deuxième substrat multicouche (400), empilant alternativement une pluralité de deuxièmes couches métalliques (21 ; 24 ; 27) et une pluralité de deuxièmes couches diélectriques (20 ; 23 ; 26 ; 29), **caractérisé en ce que** :
le premier substrat multicouche (300) comporte une zone de bordure d'au moins une première couche métallique (11 ; 14 ; 17) qui se raccorde à une zone de bordure d'une première couche diélectrique (10 ; 13 ; 16 ; 19) correspondante, et les zones de bordure sont séparées des premières couches métalliques (11 ; 14 ; 17) adjacentes et des premières couches diélectriques (10 ; 13 ; 16 ; 19) adjacentes, et **caractérisée en outre par le fait que** :
le deuxième substrat multicouche (400) a une zone de bordure d'au moins une deuxième couche de métal (21 ; 24 ; 27) qui se raccorde à une zone de bordure d'une deuxième couche diélectrique (20 ; 23 ; 26 ; 29) correspondante et les zones de bordure sont séparées des deuxièmes couches métalliques (21 ; 24 ; 27) adjacentes et des deuxièmes couches diélectriques (20 ; 23 ; 26 ; 29) adjacentes,
les VIA (1 ; 2 ; 3) étant situés au niveau des zones de bordure des premières couches diélectriques (10 ; 13 ; 16 ; 19) et chaque VIA (1 ; 2 ; 3) comporte un conducteur électrique à l'intérieur de lui pour connecter au moins une première couche métallique (11 ; 14 ; 17) à au moins une deuxième couche métallique (21 ; 24 ; 27) pour former une portion de connexion (120) ; et
le premier substrat multicouche (300) et le deuxième substrat multicouche (400) étant des substrats flexibles.

2. La structure hybride selon la revendication 1, **caractérisée en ce qu'**un procédé d'amélioration de l'adhérence d'interface (12 ; 15 ; 18) est mis en oeuvre sur des zones restantes des premières couches métalliques (11 ; 14 ; 17) et des premières couches diélectriques correspondantes (10 ; 13, 16, 19), à l'exception des zones de bordure de celles-ci, pour augmenter l'intensité d'adhésion dans les zones restantes.

3. La structure hybride selon la revendication 1, **caractérisée en ce qu'**un procédé d'amélioration de l'adhérence d'interface (22 ; 25 ; 28) est mis en oeuvre sur des zones restantes des deuxièmes couches métalliques (21 ; 24 ; 27) et des deuxièmes couches diélectriques correspondantes (20 ; 23, 26 et 29), à l'exception des zones de bordure de celles-ci, pour augmenter l'intensité d'adhésion dans les zones restantes.

4. Un procédé de fabrication d'une structure hybride de substrats multicouches (300, 400) pour connecter des dispositifs à puces (100 ; 200), **caractérisé en ce que** le procédé de fabrication comprend des étapes consistant à :
séparer une zone de bordure d'au moins une couche métallique (11 ; 14 ; 17 ; 21 ; 24 ; 27) et d'une couche diélectrique (10 ; 13 ; 16 ; 19 ; 20 ; 23 ; 26 ; 29) correspondante vis-à-vis des couches métalliques (11 ; 14 ; 17 ; 21 ; 24 ; 27) adjacentes et des couches diélectriques (10 ; 13 ; 16 ; 19 ; 20, 23, 26, 29) adjacentes pour chaque substrat multicouche (300 ; 400) ; et
relier un conducteur électrique dans un VIA (1 ; 2 ; 3) d'une première couche métallique (11 ; 14 ; 17) d'un substrat multicouche (300) à une zone de bordure séparée d'une couche métallique (21 ; 24 ; 27) d'un autre substrat multicouche (400) pour former une portion de connexion (120),
chacun des substrats multicouches (300 ; 400) étant un substrat flexible.

5. Le procédé de fabrication selon la revendication 4, **caractérisé en ce que** le procédé de fabrication comprend en outre une étape consistant à retirer une zone de bordure de la couche diélectrique (10 ; 13 ; 16 ; 19 ; 20 ; 23 ; 26 ; 29) adjacente aux dispositifs à puces (100 ; 200) pour révéler une zone de bordure de la couche métallique correspondante (11 ; 14 ; 17 ; 21 ; 24 ; 27).

6. Le procédé de fabrication selon la revendication 4, **caractérisé en ce que** le procédé de fabrication comprend en outre une étape consistant à former les substrats multicouches (300 ; 400) sur les dispositifs à puces (100 ; 200) avant l'étape consistant à séparer.

7. Le procédé de fabrication selon la revendication 6, **caractérisé en ce que** le procédé de fabrication comprend en outre une étape consistant à mettre en oeuvre un procédé (110 ; 210) d'amélioration de l'adhérence d'interface sur les dispositifs à puces (100 ; 200) lors de l'étape de formation des substrats multicouches (300 ; 400).

8. Le procédé de fabrication selon la revendication 6, **caractérisé en ce que** l'étape de formation des substrats multicouches (300 ; 400) comprend en outre les étapes consistant à :
(A) revêtir une couche diélectrique (10 ; 13 ; 16 ; 19 ; 20 ; 23 ; 26 ; 29) sur les surfaces des dispositifs à puces (110 ; 210) ;
(B) former une pluralité de VIA (1 ; 2 ; 3) au niveau de la couche diélectrique (10 ; 13 ; 16 ; 19 ; 20 ; 23 ; 26 ; 29) et d'une couche métallique (11 ; 14 ; 17 ; 21 ; 24 ; 27) sur la couche diélectrique (10 ; 13 ; 16 ; 19 ; 20 ; 23 ; 26 ; 29) ;
(C) mettre en oeuvre un procédé (12 ; 15 ; 18 ; 22 ; 25 ; 28) d'amélioration de l'adhérence d'interface sur les zones restantes de la couche métallique (11 ; 14 ; 17 ; 21 ; 24 ; 27) et de la couche diélectrique (10 ; 13 ; 16 ; 19 ; 20 ; 23 ; 26 ; 29) à l'exception de la zone de bordure pour augmenter l'intensité d'adhérence des zones restantes et revêtir une autre couche diélectrique (10 ; 13 ; 16 ; 19 ; 20 ; 23 ; 26 ; 29) ;
(D) répéter l'étape (B) et l'étape (C) pour former les substrats multicouches (300 ; 400).

9. Le procédé de fabrication selon la revendication 8,
**caractérisé en ce que** le procédé de fabrication comprend en outre une étape consistant à fournir une plaquette formant dispositif comprenant les dispositifs à puces (100 ; 200).

10. Le procédé de fabrication selon la revendication 9, **caractérisé en ce que** le procédé de fabrication comprend en outre une étape consistant à diviser les dispositifs à puces (100 ; 200) et des substrats multicouches correspondants (300 ; 400) le long des bords des zones de bordure.

11. Le procédé de fabrication selon la revendication 10, **caractérisé en ce que** le procédé de fabrication comprend en outre une étape consistant à retirer des parties de la plaquette de dispositif sans dispositifs à puces (100 ; 200) après l'étape consistant à diviser les dispositifs à puces (100 ; 200).

12. Le procédé de fabrication selon la revendication 4, **caractérisé en ce que** le procédé de fabrication comprend en outre une étape consistant à connecter des substrats multicouches (300 ; 400) à un troisième substrat (500) après l'étape de connexion, le troisième substrat (500) état un substrat flexible.
